# FASCICULE DE BREVET EUROPEEN

(11) **EP 2 311 160 B1**
(45) Date de publication et mention de la délivrance du brevet: **02.01.2013**
(21) Numéro de dépôt: 09780398.5
(22) Date de dépôt: 09.07.2009
(51) Int. Cl.: H01S 5/026, H01S 5/10, G02B 6/12, G02B 6/42

(54) **DISPOSITIF COMPRENANT UNE SOURCE LASER ET UN GUIDE D'ONDE POUR COLLECTION DE LA LUMIERE EMISE PAR LA SOURCE LASER**
VORRICHTUNG MIT EINER LASERQUELLE UND EINEM WELLENLEITER ZUM SAMMELN DES VON DER LASERQUELLE EMITTIERTEN LICHTS
DEVICE WITH LASER SOURCE AND WAVEGUIDE FOR COLLECTING THE LIGHT EMITTED BY THE LASER SOURCE

(30) Priorité: 10.07.2008 FR 0854717
(43) Date de publication de la demande: 20.04.2011
(73) Titulaire: Commissariat à l'Énergie Atomique et aux Énergies Alternatives, 75015 Paris (FR); Centre National de la Recherche Scientifique, 75794 Paris Cedex 16 (FR); Ecole Centrale de Lyon, 69134 Ecully Cedex (FR)
(72) Inventeur: MANDORLO, Fabien, F-63730 Les Martres De Veyre (FR); FEDELI, Jean-Marc, F-38120 Saint Egreve (FR); ROJO-ROMEO, Pedro, F-69006 Lyon (FR); LETARTRE, Xavier, F-69410 Champagne Au Mont D'or (FR); SEASSAL, Christian, F-69004 Lyon (FR)
(74) Mandataire: Ilgart, Jean-Christophe
(86) Numéro de dépôt international: PCT/EP2009/058778
(87) Numéro de publication internationale: WO 2010/004015

(56) Documents cités:
- WO-A-95/05020
- WO-A-97/44871
- JP-A- 3 006 080
- JP-A- 60 148 185
- JP-A- 2002 118 324
- US-A- 5 398 256

## Description

### DOMAINE TECHNIQUE

La présente invention concerne dispositif comprenant une source laser et un dispositif de collection de la lumière émise par la source laser tout en contrôlant la longueur d'onde obtenue en sortie du dispositif de collection. Elle relève du domaine de l'intégration de l'optique dans les systèmes électroniques.

### ÉTAT DE LA TECHNIQUE ANTÉRIEURE

Les sources lasers pour une intégration avec l'électronique sont actuellement réalisées selon divers procédés. Principalement, on peut distinguer les différentes techniques suivantes.

Une première technique concerne les lasers plans de type « ruban » ou à cavité « Fabry-Pérot » dont la direction d'émission est connue et dont la longueur d'onde est facilement prévisible.

Une deuxième technique concerne les lasers à « modes tournants ». Ils comprennent un disque, voire un anneau qui peut éventuellement être déformé (en hexagone, en ellipse, en stade, en ovale ...) . Le signal laser est alors récupéré en plaçant un guide à proximité de la structure émettrice et en contrôlant la distance entre les deux objets. Tout mode électromagnétique pouvant exister dans le disque est susceptible de se coupler et peut partir dans une direction quelconque du guide.

Une troisième technique concerne les lasers à cristaux photoniques CP, dont les distributions de champ permettent de réaliser des couplages selon différentes directions prévisibles par simulations. Par nature, c'est la famille la plus complexe des sources lasers, puisque les distributions électromagnétiques spatiales des modes sont très variées. Les CP peuvent aussi bien servir à réaliser des couplages dans le plan de la structure qu'avec des guides placés sur des plans différents. On peut aussi utiliser deux cristaux photoniques pour réaliser des miroirs et obtenir ainsi une cavité laser.

La collecte du signal peut se faire de plusieurs façons : pour un laser à émission verticale, on peut approcher l'extrémité d'une fibre optique de la zone d'émission.

Pour un couplage avec un simple guide, et pour des raisons de symétrie du dispositif, il est difficile de prévoir de quel côté va partir le signal lumineux pour pouvoir le collecter dans un seul et unique guide. Pour certains résonateurs, comme les disques, on peut utiliser un guide en « U » qui entoure le disque sur une seule et unique zone de transfert. Il est à noter que la distance sur laquelle s'effectue le couplage est alors nettement plus grande qu'un guide tangent, de l'ordre d'un demi-périmètre du disque.

Pour une source laser possédant deux modes dégénérés (par exemple un mode tournant dans le sens trigonométrique et l'autre mode tournant dans le sens inverse, à la même fréquence), la symétrie de couplage ne permet pas de prévoir lequel des deux modes dominera l'autre. Les incertitudes intervenant lors de la fabrication (alignement, etc.) peuvent favoriser une solution par rapport à l'autre, mais il est alors impossible de prévoir quelle sera la solution dominante.

Une solution connue consiste à placer un miroir d'un côté du guide afin d'obtenir une seule sortie optique. D'un point de vue technologique, un certain nombre d'étapes supplémentaires peut être nécessaire pour réaliser ce miroir.

Le document WO 95/05020 A divulgue un dispositif à coupleur pour collection de la lumière émise par une source laser. Ce dispositif comprend un coupleur multimode (MMI) constitué de deux entrées et deux sorties. Deux des quatre voies du MMI du coupleur sont utilisées comme cavité à la source laser. Les deux dernières voies font partie du dispositif de collection de la lumière émise par la source laser. La source laser est donc couplée au dispositif de collection de la lumière en une seule zone via le MMI.

Le document JP 03-6080 divulgue une source lumineuse à semi- conducteur comprenant deux guides d'ondes concentriques. Chacun desdits guides d'ondes est constitué de quatre tronçons linéaires reliés entre eux par réflexion à quatre coins, formant un résonateur annulaire. L'émission laser est générée dans le résonateur annulaire intérieur, puis celle- ci est transférée par couplage au résonateur annulaire extérieur et puis convertie en fréquence (SHG). Le rayonnement du second harmonique est extrait à l'aide d'un guide d'onde couplé à un des coins du résonateur extérieur.

### EXPOSÉ DE L'INVENTION

Il est proposé par la présente invention un dispositif simple à réaliser et qui se contente de prélever et faire interagir la lumière issue de la source laser. Ce dispositif permet de faire interférer un certain nombre de signaux lumineux issus de différents points de collection sur la source laser, afin d'en contrôler la résonance et récupérer un signal résultant dans un seul et unique guide.

L'invention a pour objet un dispositif comprenant une source laser et un dispositif de collection de la lumière, permettant de recueillir un signal lumineux émis par la source laser. L'invention peut réaliser deux fonctions principales : elle peut servir à sélectionner (voire ajuster) les longueurs d'ondes disponibles après collection, et permet de récupérer un signal optique dans un seul et unique guide.

L'invention a pour objet un dispositif comme défini dans la revendication 1.

Des modes particuliers de mise en oeuvre sont définis dans les revendications dépendants.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est un schéma explicatif d'un dispositif de collection de la lumière émise par une source laser,
- la figure 2 illustre un premier mode de mise en oeuvre de l'invention,
- la figure 3 illustre un deuxième mode de mise en oeuvre de l'invention,
- la figure 4 illustre un troisième mode de mise en oeuvre de l'invention,
- la figure 5 illustre une variante de réalisation du premier mode de mise en oeuvre de l'invention.

### EXPOSÉ DÉTAILLÉ DE MODES DE RÉALISATION PARTICULIERS

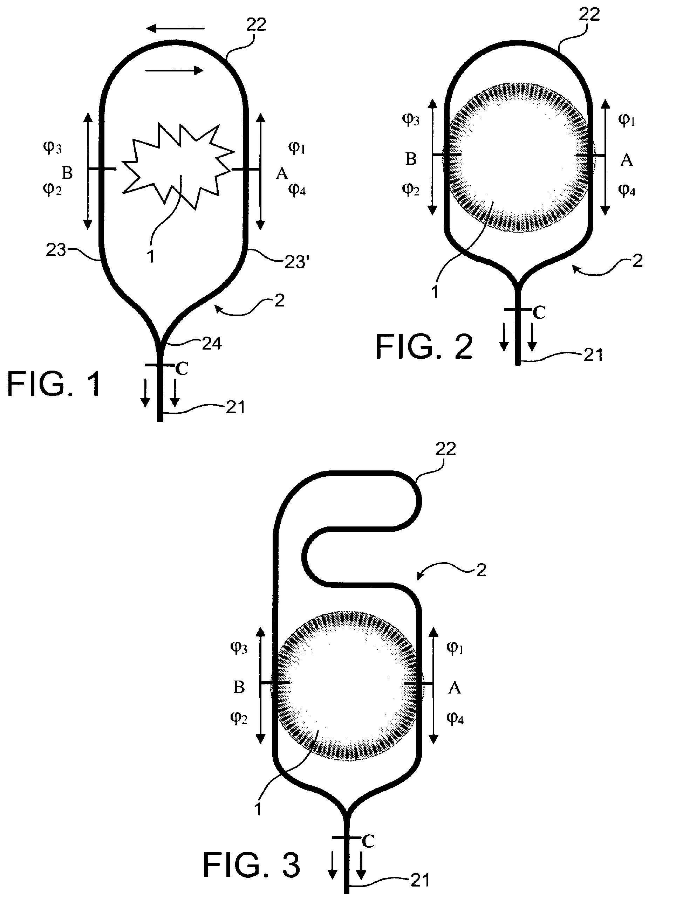

La figure 1 est un schéma explicatif d'un dispositif de collection de la lumière émise par une source laser.

Sur cette figure, la référence 1 représente une source optique et la référence 2 représente un guide d'onde optique. Le guide d'onde optique 2 comprend plusieurs tronçons, chacun jouant un rôle différent. Le tronçon 21 est destiné à véhiculer le signal lumineux fourni par la source optique 1 dans la direction indiquée par les flèches. Le tronçon 22 relie deux points de couplage du guide d'onde 2 avec la source optique 1. Les tronçons 23 et 23' permettent de véhiculer vers le tronçon 21 les signaux captés aux points de couplage. Ils récupérent non seulement les signaux se dirigeant directement vers le tronçon 21, mais aussi les signaux se dirigeant dans l'autre sens et récupérés par le tronçon 22. Les tronçons 23 et 23' permettent donc de récupérer des signaux optiques après qu'ils aient interféré avec la source optique via le tronçon 22. Les tronçons 23 et 23' sont reliés à un coupleur 24 de sorte à fournir dans le tronçon 21 un signal de sortie du dispositif. Le guide d'onde 2 a donc la forme générale d'une boucle.

Le guide d'onde optique 2 est disposé de façon à recueillir par couplage un signal lumineux émis par la source optique. La collecte du signal lumineux se fait à deux endroits distincts du guide d'onde, voire plus, de sorte à réaliser des interférences optiques selon les conditions de phases imposées par la source aux points de couplage et le parcours de la lumière dans le guide d'onde 2.

Dans l'exemple représenté sur le schéma de la figure 1, la boucle constituée par les tronçons 22, 23 et 23' de guide d'onde entoure la source optique 1 et est disposée de façon à pouvoir recueillir et faire interférer le signal lumineux émis par la source en deux endroits désignés par les lettres A et B.

La source optique 1 peut se trouver indifféremment dans le même plan que le guide d'onde optique 2, dans un plan inférieur à celui du guide d'onde optique ou dans un plan supérieur. La source laser et le guide d'onde optique 2 sont physiquement séparés. Aux zones de couplage entre la source laser et le guide d'onde (au voisinage des points A et B), la source laser et le guide d'onde peuvent être séparés par un matériau de faible indice de réfraction tel que de la silice SiO₂, sur une distance comprise entre 10 nm et 500 nm. La forme donnée à la boucle n'a pas d'importance en soi puisque seuls comptent les chemins optiques. En fait, on peut constater qu'il y a deux zones importantes du guide d'onde optique 2 : la zone de fond de boucle (c'est-à-dire celle comprise entre les points A et B et opposée au coupleur deux-vers-un 24, donc le tronçon 22) et la zone reliant le tronçon 22 au coupleur deux-vers-un 24.

La zone de fond de boucle intervient dans la sélection du mode qui va arriver en C (voir la figure 1), c'est-à-dire dans le premier tronçon 21.

En effet, pour que le signal de phase ϕ₁ issu de A et se dirigeant vers le fond de boucle puisse sortir de la boucle, il doit passer par B : les conditions d'interférences en ce second point avec la phase dans le résonateur permettent alors, selon que l'on ait des interférences constructives ou destructives, de modifier les pertes globales de l'ensemble constitué par le laser et le tronçon 22. Ainsi, on peut trouver des conditions (sur l'indice et la longueur physique) du tronçon 22 de sorte à ce qu'on ait peu de pertes pour une longueur d'onde de résonance de la source sur l'ensemble des longueurs d'onde de résonance possibles de cette dernière, et ainsi pouvoir obtenir un fonctionnement laser à cette longueur d'onde bien précise.

Contrôler le chemin optique 22 permet donc de contrôler la condition d'interférence, et donc les pertes, et donc plus indirectement la longueur d'onde laser.

Par symétrie, le signal se propageant dans l'autre sens (de B vers A) obéit aux mêmes propriétés que citées précédement.

Dans le cas d'une source à modes dégénérés (micro-disques, anneaux et tores), on peut satisfaire les mêmes conditions d'interférences pour les deux sens de propagation (A vers B et B vers A).

Plus le couplage en A et B est intense, plus l'influence des interférences aux zones de couplage est conséquente.

L'autre zone importante du guide d'onde optique 2 est la zone située entre les points A et B d'une part et le point C d'autre part. Pour cette zone, si les différents modes dégénérés de la source laser cohabitent dans les guides, leur interférence en C peut mener à la présence ou pas de signal dans le tronçon 21. Le choix des chemins optiques δ_{BC} (tronçon 23) et δ_{AC} (tronçons 23') qui ne sont pas nécessairement identiques, dépend de la longueur d'onde du mode laser, et des phases ϕ₂ et ϕ₄.

Dans tous les cas, le signal de sortie est récupéré dans un seul guide, après le point C. Cette solution a l'avantage de ne requérir aucune étape supplémentaire par rapport à un simple guide qu'on viendrait coupler au résonateur, puisque cette boucle est réalisée en même temps que le reste du guide. L'absence de miroir de renvoi (comme dans l'art antérieur) et la symétrie éventuelle selon le sens de propagation des modes simplifient grandement la réalisation.

Dans le fonctionnement du dispositif selon l'invention, on peut distinguer trois cas.

Selon un premier cas, le laser 1 possède un mode permettant une propagation de la lumière dans le guide d'onde optique 2 selon le trajet B→A→C. Le tronçon 23 n'est pas parcouru par la lumière. Le tronçon 22 a un chemin optique induisant un déphasage de l'onde qui s'y propage. Les photons issus du point B peuvent parcourir deux chemins avec un déphasage différent : un chemin constitué par le tronçon 22 et un chemin dans le laser lui-même entre les deux zones de couplage. En A, ils peuvent interférer constructivement, induisant un niveau de pertes important pour le laser, c'est-à-dire que beaucoup de photons peuvent quitter le laser pour aller dans le guide d'onde. En conséquence, le laser peut ne pas atteindre le régime laser en fonction du couplage entre le laser et le guide d'onde en A et B. Dans le cas contraire (interférences destructives), le laser se comporte presque comme si le guide d'onde était absent. Les pertes de l'ensemble de la structure sont alors très faibles et se rapprochent de celles que subit le laser seul. La différence de pertes correspond alors à la quantité de lumière résultant des interférences en A et qui se dirige vers le point C pour se propager dans le tronçon 21.

Selon un deuxième cas, le laser 1 possède un mode permettant une propagation de la lumière dans le guide d'onde optique 2 selon le trajet A→B→C. Ce cas correspond au cas précédent en remplaçant le point B par le point A et inversement. C'est le tronçon 23' qui dans ce cas n'est pas parcouru par la lumière.

Selon un troisième cas (mode stationnaire), le tronçon 22 joue un rôle identique pour les deux modes précédents, c'est-à-dire que les chemins optiques sont identiques mais qu'ils sont parcourus dans des sens opposés. Comme pour les cas précédents, si les interférences en A et B sont constructives, le laser pourra ne pas atteindre le régime laser, ce qui signifiera alors qu'il n'y a pas de signal en sortie dans le tronçon 21. Dans le cas contraire, la source maintiendra son régime laser, mais il faut s'intéresser aux tronçons 23 et 23' pour savoir s'il y a un signal en sortie dans le tronçon 21. La différence de phase au point C entre les photons issus des points A et B peut mener à des interférences constructives (un signal est présent au point C) ou destructrices (pas de signal au point C) ou mener à des solutions intermédiaires. On peut noter le cas très particulier de la source laser à mode de galerie : avec un chemin symétrique, un mode laser sur deux est en interférences destructives au point C lorsque les autres sont en interférences constructives.

Il est envisageable d'utiliser des moyens actifs (thermiquement par exemple, ou en modifiant la concentration de porteurs (avec un champ électrique, ou par tout autre moyen)) pour contrôler les différents chemins optiques afin de, par exemple, à l'aide du tronçon 22 :
- compenser d'éventuels désalignements, et donc de légers changements sur le chemin optique du tronçon 22, entre la lithographie des guides et celle de la source, si ces deux objets sont réalisés l'un après l'autre.
- modifier légèrement (sur quelques nanomètres) la longueur d'onde laser (« tuning/trimming »)
- contrôler la longueur d'onde laser en choisissant le tronçon 22 de sorte qu'en modifiant légèrement son chemin optique, on puisse passer d'un mode laser à un autre en réduisant considérablement les pertes associées aux longueurs d'onde correspondantes.

Une actuation du chemin optique δ_{BC} ou δ_{AC} peut être nécessaire si la longueur d'onde est ammenée à varier, ou si l'on veut utiliser les interférences au niveau du coupleur pour faire de la modulation.

Etant donné que tous les tronçons de guide d'onde sont lithographiés en même temps, aucune étape supplémentaire n'est nécessaire pour fabriquer le dispositif si on utilise une technologie similaire à celle développée dans le projet WADIMOS (http://wadimos.intec.ugent.be/) et qu'on ne souhaite pas inclure d'éléments actifs, mais juste favoriser un mode particulier.

L'utilisation d'un substrat SOI ou de silicium amorphe permet de disposer la source optique au-dessus ou au-dessous du plan de la boucle. Cependant, on peut aussi bien envisager de lithographier la source optique en même temps que le guide d'onde 2. Dans le cas d'une correction active du chemin optique par des actionneurs, un certain nombre d'étapes supplémentaires seront nécessaires. Cependant, ces étapes supplémentaires sont connues de l'homme de l'art.

La figure 2 illustre un premier mode de mise en oeuvre de l'invention. La source optique 1 est ici constituée d'un micro-disque à modes de galerie. Le guide d'onde optique 2 comprend un premier tronçon 21 identique au premier tronçon de la figure 1. Il comprend aussi un deuxième tronçon 22 constituant la boucle du dispositif. Dans cet exemple de réalisation, la boucle est symétrique.

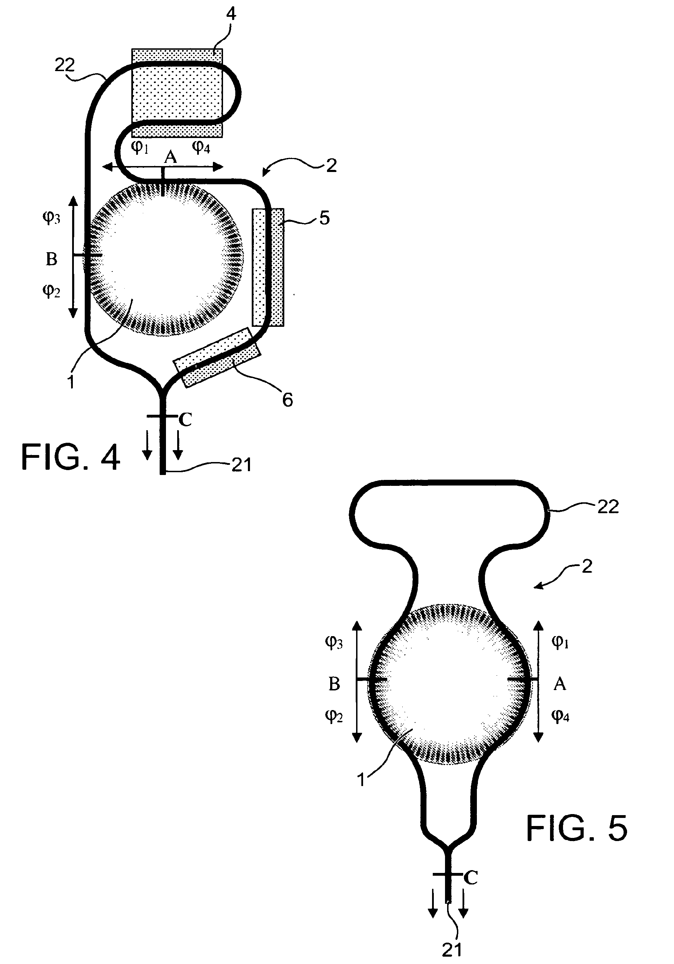

La figure 5 montre une variante du premier mode de réalisation. La source optique 1 est ici constituée d'un résonateur en anneau. Cette figure représente un cas dans lequel le couplage se fait selon des zones de couplage et non pas des points de couplage, ce qui convient bien aux guides courbés. Dans cet exemple de réalisation, la boucle est symétrique et les zones de couplage ne sont pas ponctuelles.

La figure 3 illustre un deuxième mode de mise en oeuvre de l'invention. La source optique 1 est ici constituée d'un micro-disque à modes de galerie. Le guide d'onde optique 2 comprend un premier tronçon 21 identique au premier tronçon de la figure 1. Il comprend aussi un deuxième tronçon 22 constituant la boucle du dispositif. Dans cet exemple de réalisation, la boucle est asymétrique.

La figure 4 illustre un troisième mode de mise en oeuvre de l'invention. La source optique 1 est ici aussi constituée d'un micro-disque à modes de galerie. Le guide d'onde optique 2 comprend un premier tronçon 21 identique au premier tronçon de la figure 1. Il comprend aussi un deuxième tronçon 22 constituant la boucle du dispositif. Dans cet exemple de réalisation, la boucle est asymétrique et comprend des actionneurs 4, 5 et 6 pour contrôler les chemins optiques. L'actionneur 4 contrôle le chemin optique δ_{AB}, tandis que les actionneurs 5 et 6 contrôlent le chemin optique δ_{AC}.

L'actionneur 4 permet de contrôler la condition d'interférence au point B pour les modes propagatifs et au point A pour les modes contrapropagatifs, un mode stationnaire étant une combinaison des deux types de modes précédents. L'actionneur peut être un actionneur thermique. On pourra se référer à ce sujet à l'article « High-speed optical modulation based on carrier depletion in a silicon waveguide », A. Liu et al., Optics Express, vol. 15, N°2, 22 Janvier 2007, pages 660 à 668. On peut aussi utiliser des portions de guide dans lesquelles on joue sur la déplétion de porteurs pour en faire varier l'indice optique. Cette seconde façon de faire est souvent utilisée sur les modulateurs. Cet actionneur permet d'interagir avec la source laser pour définir la longueur d'onde des signaux véhiculés par les tronçons 23 et 23'. On peut donc choisir un signal laser ou pas (rôle de modulation) ou passer d'une longueur d'onde à une autre (saut de mode), voire ajuster finement la longueur d'onde. Il est tout à fait envisageable qu'un même actionneur puisse à la fois faire du saut de mode, de la modulation et de l'ajustement en longueur d'onde.

Les actionneurs situés ailleurs que sur le tronçon 22 jouent un rôle différent de celui situé sur ce tronçon puisqu'ils ne permettent pas de contrôler la longueur d'onde laser. Ils peuvent permettre de corriger une légère dissymétrie des chemins 23 et 23' pour optimiser la condition d'interférence au point C. Ils peuvent aussi servir à moduler l'intensité du signal résultant dans le tronçon 21, auquel cas une dissymétrie des chemins 23 et 23' est préférable.

Les effets de contrôle de l'indice optique peuvent être par déplétion de porteurs et sont décrits, par exemple, dans les documents suivants :
- « Low loss and high speed silicon optical modulator based on a lateral carrier depletion structure » de D. Marris-Morini et al., Optics Express, vol. 16, N°1, 7 janvier 2008, pages 334 à 339 ;
- "Reconfigurable Optical Add-Drop Multiplexer Using Microring Resonators" par E.J. Klein et al., IEEE Photonics Technology Letters, vol. 17, N°11, novembre 2005, pages 2358 à 2360.

L'invention s'applique en particulier dans le domaine des coupleurs optiques sélectifs en longueur d'onde dans les circuits intégrés comportant des sources optiques (micro-résonateurs à mode de galerie, cristaux photoniques, etc...) pour la récupération d'un signal dans un seul et unique guide.

## Revendications

1. Dispositif comprenant une source laser (1) et un guide d'onde optique continu (2) recueillant, par couplage, un signal lumineux émis par la source laser, le signal lumineux étant émis par la source laser en au moins deux zones distinctes, où : -le guide d'onde (2) comprend une partie
- le guide d'onde (2) comprend une partie destinée à véhiculer le signal lumineux en sortie du dispositif et une partie formant une boucle recueillant par couplage le signal lumineux émis par la source laser en au moins deux zones de couplage, la boucle étant séparée de la source laser, au niveau des zones de couplage, par un matériau de faible indice de réfraction,
- la boucle comprend un premier tronçon (23) prolongé par un deuxième tronçon (22) prolongé par un troisième tronçon (23'), le deuxième tronçon (22), ou tronçon de récupération, reliant la première zone de couplage de la boucle à la deuxième zone de couplage de la boucle,
- les premier et troisième tronçons (23, 23'), ou tronçons de jonction, relient le deuxième tronçon (22) respectivement à des première et deuxième entrées d'un coupleur deux-vers-un (24) dont la sortie est connectée à un quatrième tronçon (21) constituant la partie destinée à véhiculer le signal lumineux en sortie du dispositif,
- le deuxième tronçon (22) présente un chemin optique prévu pour qu'il y ait des interférences, à chacune des zones de couplage, entre la partie du signal lumineux captée à l'une des zones de couplage, et véhiculée par le tronçon de jonction correspondant, et la partie du signal lumineux captée à l'autre zone de couplage et véhiculée par le tronçon de récupération (22),
- les premier et troisième tronçons (23, 23') présentent des chemins optiques prévus pour qu'il y ait des interférences dans le coupleur deux-vers-un (24) entre les signaux véhiculés par les tronçons de jonction (23, 23'), et
- le coupleur deux-vers-un (24) est un coupleur en Y ou un coupleur interférométrique multimode (MMI).

2. Dispositif selon la revendication 1, dans lequel la boucle entoure la source laser (1).

3. Dispositif selon l'une des revendications 1 ou 2, dans lequel la boucle a une forme symétrique, partiellement symétrique ou asymétrique.

4. Dispositif selon l'une quelconque des revendications 1 à 3, comprenant en outre des moyens actifs (4, 5, 6) de contrôle du chemin optique d'au moins une partie de la boucle.

5. Dispositif selon l'une quelconque des revendications 1 à 4, dans lequel les zones de couplage sont ponctuelles.

## Claims

1. Device comprising a laser source (1) and a continuous optical waveguide (2) collecting a light signal emitted by the laser source by coupling, the light signal being emitted by the laser source in at least two distinct zone, wherein:
- the waveguide (2) comprises a part that will transport the light signal output from the device and a part forming a loop collecting the light signal emitted by the laser source in at least two coupling zones by coupling, the loop being separated from the laser source at the coupling zones by a material with a low refraction index,
- the loop comprises a first segment (23) prolonged by a second segment (22) prolonged by a third segment (23'), the second segment (22), namely the recovery segment, connecting the first coupling zone of the loop to the second coupling zone of this loop,
- the first and third segments (23, 23'), namely the junction segments, connect the second segment (22) to the first and second inputs respectively of a two-to-one coupler (24), the output of which is connected to a fourth segment (21) forming the part that will transport the light signal output from the device,
- the second segment (22) has an optical path designed so that there is interference in each of the coupling zones, between the part of the light signal captured at one of the coupling zones and transported by the corresponding junction segment, and the part of the light signal captured at the other coupling zone and transported by the recovery segment (22),
- the optical paths of the first and third segments (23, 23') are arranged so that there is interference in the two-to-one coupler (24) between signals transported by the junction segments (23, 23'), and
- the two-to-one coupler (24) is a Y coupler or a multimode interferometric (MMI) coupler.

2. Device according to claim 1, in which the loop surrounds the laser source (1).

3. Device according to either claim 1 or 2, in which the shape of the loop is symmetric, partly symmetric or asymmetric.

4. Device according to any one of claims 1 to 3, also comprising active means (4, 5, 6) for controlling the optical path of at least part of the loop.

5. Device according to any one of claims 1 à 4, in which the coupling zones are isolated.

## Patentansprüche

1. Vorrichtung umfassend eine Laserlichtquelle (1) und einen kontinuierlichen optischen Wellenleiter (2), welcher mittels Kopplung ein von der Laserquelle emittiertes Lichtsignal aufnimmt, wobei das Lichtsignal von der Laserquelle in wenigstens zwei distinkten Zonen emittiert wird und wobei:
-- der Wellenleiter (2) einen zur Übertragung des Lichtsignals im Ausgang dienenden Teil und einen eine Schleife bildenden Teil aufweist, welcher das von der Laserquelle emittierte Lichtsignal mittels Kopplung in wenigstens zwei Kopplungszonen aufnimmt, wobei die Schleife auf dem Niveau der Kopplungszonen von der Laserquelle durch ein Material von niedrigem Brechungsindex getrennt ist;
-- die Schleife einen ersten Abschnitt (23) aufweist, der durch einen zweiten Abschnitt (22) verlängert ist, der seinerseits durch einen dritten Abschnitt (23') verlängert ist, und wobei der zweite oder Nutzsignalgewinnungsabschnitt (22) die erste Kopplungszone der Schleife mit der zweiten Kopplungszone der Schleife verbindet,
-- der erste und der dritte Abschnitt oder Verbindungsabschnitt (23, 23') den zweiten Abschnitt (22) mit den ersten bzw. zweiten Eingängen eines Zwei-in-Eins- Kopplers (24) verbindet, dessen Ausgang mit einem vierten Abschnitt (21) verbunden ist, welcher den zur Übertragung des Lichtsignals im Ausgang der Vorrichtung bestimmten Teil bildet,
-- der zweite Abschnitt (22) einen optischen Weg darstellt, der dazu bestimmt ist, in jeder der Kopplungszonen Interferenzen herbeizuführen zwischen dem Teil des Lichtsignals, der in einer der Kopplungszonen ausgenommen und durch den entsprechenden Verbindungsabschnittt transportiert wird und dem Teil des Lichtsignals, der in der anderen Kopplungszone aufgenommen: und durch den Nutzsignalgewinnungsabschnitt (22) transportiert wird,
-- der erste und dritte Abschnitt (23, 23') optische Wege darstellen, die vorgesehen sind, um in dem Zwei-in-Eins-Koppler (24) Interferenzen zwischen den von den Verbindungsabschnitten (23, 23') transportierten Signalen herbeizuführen,
-- und wobei der Zwei-in-Eins- Koppler (24) ein Y-Koppler oder ein interferometrischer Multimode-Koppler (MMI) ist.

2. Vorrichtung nach Anspruch 1, bei welcher die Schleife die Laserquelle umgibt.

3. Vorrichtung nach einem der Ansprüche 1 oder 2, bei welcher die Schleife symmetrische, teilweise symmetrische oder asymmetrische Form besitzt.

4. Vorrichtung nach einem beliebigen der Ansprüche 1 bis 3, des Weiteren umfassend aktive Mittel (4, 5, 6) zur Kontrolle des optischen Wegs wenigstens eines Teils der Schleife.

5. Vorrichtung nach einem beliebigen der Ansprüche 1 bis 4, bei welcher die Kopplungszonen punktförmig sind.
